(19) Europäisches Patentamt / European Patent Office / Office européen des brevets

(11) **EP 3 978 731 A1**

(12) **EUROPEAN PATENT APPLICATION**
published in accordance with Art. 153(4) EPC

(43) Date of publication:
**06.04.2022  Bulletin 2022/14**

(21) Application number: **19931178.8**

(22) Date of filing: **31.12.2019**

(51) International Patent Classification (IPC):
**F01K 25/08** $^{(2006.01)}$

(52) Cooperative Patent Classification (CPC):
**C09K 5/04; F01K 25/08; H05K 7/20**

(86) International application number:
**PCT/CN2019/130393**

(87) International publication number:
**WO 2020/238207 (03.12.2020 Gazette 2020/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.05.2019  CN 201910461222**

(71) Applicants:
• **Zhejiang Research Institute of Chemical Industry Co., Ltd.**
  **Hangzhou, Zhejiang 310023 (CN)**
• **Sinochem Lantian Co., Ltd.**
  **Hangzhou, Zhejiang 310051 (CN)**

(72) Inventors:
• **QUAN, Hengdao**
  **Hangzhou, Zhejiang 310023 (CN)**

• **GUO, Zhikai**
  **Hangzhou, Zhejiang 310023 (CN)**
• **ZHAO, Sheng**
  **Hangzhou, Zhejiang 310023 (CN)**
• **OUYANG, Hongsheng**
  **Hangzhou, Zhejiang 310023 (CN)**
• **YANG, Huie**
  **Hangzhou, Zhejiang 310023 (CN)**
• **SUN, Huafeng**
  **Hangzhou, Zhejiang 310023 (CN)**
• **YANG, Gang**
  **Hangzhou, Zhejiang 310023 (CN)**
• **LUO, Xia**
  **Hangzhou, Zhejiang 310023 (CN)**

(74) Representative: **Kransell & Wennborg KB**
  **P.O. Box 2096**
  **403 12 Göteborg (SE)**

(54) **ENVIRONMENT-FRIENDLY HEAT PIPE WORKING FLUID**

(57)    The invention provides a gravity heat pipe having a working fluid selected from the group consisting of HFO-1234ze(Z), HFO-1234ze(E), HFO-1336mzz(Z), HFO-1336mzz(E), HFO-1224yd(Z), HFO-1233zd(E), and a mixture thereof. The heat pipes of the invention are environmentally friendly, have good cooling performance and low manufacturing costs, and are suitable for cooling of communication base stations, servers, or data centers.

FIG. 1

EP 3 978 731 A1

**Description**

FIELD OF THE INVENTION

The present invention relates to a cooling medium, particularly to a gravity type heat pipe cooling medium.

BACKGROUND OF THE INVENTION

In recent years, the rapid development of the Internet industry has resulted in a rapid rise of Internet Data Center (IDC), and the IDC market demand has increased rapidly. In 2016, Chinese IDC market reached 71.45 billion yuan. It is expected that the Chinese IDC market will reach 180 billion yuan by 2019. The energy consumption of the data center has also increased rapidly. In 2016, the power consumption of data centers in China exceeded 100 billion kW•h, exceeding the annual power generation capacity of the entire Three Gorges Power Station (90 billion kW•h), accounting for 1% of total electricity in the nation, reaching 2% of total global electricity consumption.

IDC's energy consumption includes IT equipment, refrigeration equipment, power distribution systems, and other auxiliary equipment. The power consumption of refrigeration equipment accounts for 40% of the total power consumption of IDC. Therefore, energy-saving refrigeration technology is needed to reduce the PUE value of the data center. It is one of the effective ways to build a green energy-saving data center in China. As far as the refrigeration equipment is concerned, the conventional precision air conditioner has the problem of low energy utilization rate and uneven distribution of airflow organization, and it is unable to meet the cooling demand of the server cabinet with an increase in the amount of heat generation and a sharp rise in the heat density.

The gravity type heat pipes are an energy-efficient and emission-reducing refrigeration equipment with good cooling effect and low energy consumption. A gravity heat pipe is a sealed pipe containing a working fluid in a state that contains both liquid and gas phases of the working fluid. The liquid phase is converted into the gas phase by absorbing latent heat in the evaporation zone. The gas travels to the condensation zone, where the gas is condensed back into the liquid phase releasing latent heat. With the help of gravity, the condensed liquid moves back to the evaporation zone to complete the cycle. Gravity heat pipes are typically small in sizes and can be installed on the back of the rack or as the side panel of the base station. Gravity heat pipes not only can achieve one-to-one cooling, avoid local hot spots, but also can increase the utilization rate of the equipment room.

In the working temperature range of 0-100 °C, the commonly used working fluids for gravity type heat pipes include water, ammonia, methanol, acetone, HCFC-22, HFC-134a, R410a, and so on. Considering safety and environmental protection requirements, these working fluids have insurmountable shortcomings. The starting temperature for water is high, and the unit must be well protected against potential leakage. Ammonia is strongly irritating, and ammonia leakage can cause poisoning. Methanol and acetone are flammable and not suitable for large-volume uses. HCFC-22 can destroy the ozone layer and its global warming potential (GWP) is 1810. Although HFC-134a and R410a will not destroy the ozone layer, their GWP values are 1300 or more, and their system pressures are high, thereby rendering the manufacturing costs high.

At present, a safe and feasible alternative to gravity heat pipe system working fluids is HFC-245fa, which is non-flammable and has a low system pressure. This working fluid can meet the requirements for related applications. However, because HFC-245fa has a GWP value of 1050, it may be replaced in the future. Therefore, it is necessary to develop an environmentally friendly working fluid suitable for gravity heat pipes to replace HFC-245fa for heat pipe cooling.

SUMMARY OF THE INVENTION

An object of the present invention is to provide gravity heat pipe working fluids, which can be used for gravity heat pipe cooling.

Embodiments of the invention relate to a gravity heat pipe having a working fluid selected from the group consisting of HFO-1234ze(Z), HFO-1234ze(E), HFO-1336mzz(Z), HFO-1336mzz(E), HFO-1224yd(Z), HFO-1233zd(E), and a mixture thereof. In preferred embodiments, the working fluid is HFO-1234ze(Z), HFO-1234yf, HFO-1233zd(E), HFO-1224yd(Z), or a mixture thereof. In more preferred embodiments, the working fluid is HFO-1234ze(Z). HFO-1234ze(Z) is cis-1,3,3,3-tetrafluoropropene, with a molecular formula of $CHFCHCF_3$, a molecular weight of 114.04, a standard boiling point of 9.72 °C, a critical temperature of 150.12 ° C, and a critical pressure of 3.53 MPa.

The invention provides a method for using a gravity heat pipe working fluid, and a cooling working fluid containing HFO-1234ze(Z) is used in a gravity heat pipe.

In preferred embodiments, the working fluid consists solely of HFO-1234ze(Z).

In preferred embodiments, the gravity heat pipe is operated at a temperature of 0 to 100 °C.

The working fluids of the invention is suitable for directly replacing the medium in a gravity heat pipe originally designed to use HFC-245fa, HFC-134a or R410a. That is, a working fluid of the present invention can be used to replace the original design using HFC-245fa, HFC-134a, or R410a.

A gravity heat pipe device of the invention adopts a design of separate evaporation section and the condensation section, which are connected by pipelines. A gravity heat pipe device of the invention can realize long-distance heat transfer and adjust the heat exchange area ratio according to needs, and meet the IDC refrigeration requirements of different scales. As a preferred mode, a gravity heat pipe of the invention is a flat-plate gravity heat pipe.

The gravity heat pipe devices of the invention are particularly suitable for cooling of electronic equipment, such as computers, communication base stations, servers, or data centers.

The gravity heat pipe working fluids of the invention have the following advantages, as compared with the prior art working fluids:

(1) Excellent environmental performance, ODP value is 0, GWP value is <1;
(2) good heat transfer performance, the Merit numbers M' of reaction thermal physics and heat transfer comprehensive performance are higher than that of HFC-245fa, which is the working fluid of choice for cooling IDCs;
(3) In the operating temperature range of 0-100 ° C, the heat exchange performance is good, and the saturated vapor pressures are low. Therefore, the manufacturing costs for such systems are low;
(4) Good stability and high safety.

The specific expression of the gravity heat pipe working fluid Merit number (or Figure of Merit) M' for a gravity type heat pipe (i.e., thermosyphon) of the present invention is as follows:

$$M' = \left( \frac{L k_l^3 \rho_l^2}{\mu_l} \right)^{\frac{1}{4}}$$

wherein the dimension of the merit number $M'$ is $\frac{kg}{K^{3/4} S^{5/2}}$ , wherein L is the latent heat of vaporization with a dimension of (kJ/kg); $\rho_l$ is the density of the saturated liquid, with a dimension of kg/m$^3$; $k_l$ is the liquid thermal conductivity; and $\mu_l$ is the hydrodynamic viscosity with a dimension of Pa•s.

The ODP value of the heat pipe working fluid of the present invention is obtained by testing CFC-11 as a reference value of 1.0, and the GWP value is obtained by using CO2 as a reference value of 1.0 (100 years).

BRIEF DESCRIPTION OF THE DRAWINGS

FIG. 1 shows the saturation vapor pressures of various gravity heat pipe working fluids in a temperature range between 0 °C and 100 °C;
FIG. 2 shows the Merit Numbers (M') for various gravity heat pipe working fluids in a temperature range between 0 °C and 100 °C;
FIG. 3 shows a schematic diagram of a process flow for a gravity heat pipe setup.

DETAILED DESCRIPTION

Embodiments of the invention will be illustrated with the following examples. However, the invention is not limited to the specific examples. Those skilled in the art will recognize that the invention encompasses other alternatives, modifications, and equivalents that may be included within the scope of the claims.

Embodiments of the invention relate to working fluids for heat pipes (e.g., gravity type heat pipes), particularly those for cooling electronic equipment, such as computers, communication base stations, servers, or internet data centers (IDC), to name a few. A heat pipe uses phase changes (e.g., between liquid and gas phases) of a working fluid to transfer heat from one location to another. Proper functioning of a heat pipe requires a saturated working fluid.

The working fluid absorbs latent heat (heat of evaporation) when evaporating from the liquid phase to the gas phase in the evaporator zone and releases latent heat when the gas is cooled and condensed back to liquid in the condenser zone.

Because a heat pipe functions under saturated conditions (i.e., co-existence of liquid and gas phases in the heat pipe), the first factor to consider in selecting a working fluid is the operating temperature range, which should be between the triple (freezing) point and the critical point of the working fluid. In reality, the operating temperature range for any given fluid is smaller, because the power that the heat pipe can carry drops off sharply near the freezing and critical temperatures. If the operating temperatures are too high, the fluid may not be able to condense. However, if the operating temperatures are too low the fluid will not be able to evaporate. For applications in cooling electronic equipment, such as those in IDC, the operating temperature rage is typically between 0 to 150 °C, more commonly between 0 to 100 °C.

Many potential working fluids can function in this temperature range. Proper choices for working fluids would depend on many factors related to the properties of the working fluids.

Environmental Performance

Climate change is an urgent problem. Any working fluids should have no or little environmental impact, i.e., no ozone depletion potential (ODP) and low global warming potential (GWP). Based on the ODP and GWP values, several candidate working fluids listed in Table 1 are selected as candidate working fluids. It can be seen from Table 1 that all these working fluids all have zero or very low ODP. Some of these working fluids have high GWP, and some have very low GWP Based on these environmental performance parameters, promising working fluids include, for example, HFO-1234yf, HFO-1234ze(Z), HFO-1234ze(E), HFO-1233zd(E), HCFO-1224yd(Z), HFO-1336mzz(Z), HFO-1336mzz(E), and a combination of these working fluids.

Table 1

| Working Fluid | ODP | GWP |
|---|---|---|
| HFC-134a | 0 | 1430 |
| R410a | 0 | 2100 |
| HCFC-22 | 0.05 | 1810 |
| HFC-245fa | 0 | 1050 |
| HFO-1234yf | 0 | <1 |
| HFO-1234ze(Z) | 0 | <1 |
| HFO-1234ze(E) | 0 | <1 |
| HFO-1233zd(E) | 0.00034 | 1 |
| HCFO-1224yd(Z) | 0.00012 | <1 |
| HFO-1336mzz(Z) | 0 | 2 |
| HFO-1336mzz(E) | 0 | 7 |

Saturation Vapor Pressure

Because a heat pipe uses phase changes (e.g., between liquid and gas phases) of a working fluid to transfer heat from one location to another, the working fluid should have sufficient saturation vapor pressures within the operating temperature range to conduct sufficient heat. On the other hand, the saturation vapor pressures of the working fluids in the operating temperature range should not be too high. Otherwise, it may exert too much pressure on the heat pipe envelope. Therefore, a good working fluid should have sufficient vapor pressures within the operating temperature range. In addition, the pressure change as a function of temperature should not be too steep.

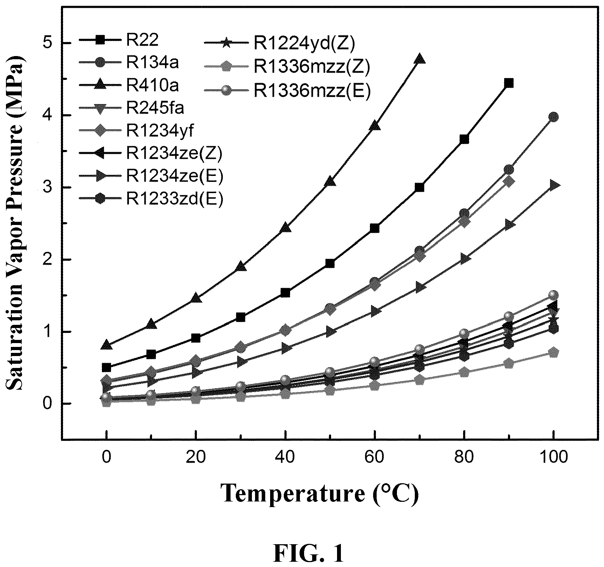

FIG. 1 shows saturation vapor pressures as a function of temperatures for various candidate working fluids. As shown in FIG. 1, while most working fluids shown have acceptable vapor pressures within the operating temperature range of 0-100 ° C, some have better vapor pressure-temperature profiles. For example, HFO-1336mzz(E), HFO-1234ze(Z), HFO-1233zd(E), HCFO-1224yd(Z), and HFO-1336mzz(E) have similar saturation vapor pressures and temperature dependency as those of HFC-245fa. These properties suggest that these working fluids can be "drop-in" replacements for HFC-245fa - i.e., it is probably unnecessary to modify the pipes when replacing HFC-245fa with any of these working fluids.

On the other hands, R410a, HCFC-22, HFC-134a, HFO-1234yf, and HFO-1234ze(E) have significantly higher saturation vapor pressures and also have higher temperature dependencies, as compared to those of HFC-245fa. These properties suggest that these working fluids should not be used as drop-in replacements for HFC-245fa. Among these working fluids, R134a and HFO-1234yf have very similar properties, making HFO-1234yf a suitable drop-in replacement for R134a. Interestingly, the trans isomer, HFO-1234ze(E), has much higher saturation vapor pressures and temperature dependency, as compared to its cis isomer, HFO-1234ze(Z).

From this group, working fluids with preferable profiles include HFO-1336mzz(E), HFO-1234ze(Z), HFC-245fa, HCFO-1224yd(Z), HFO-1233zd(E), and HFO-1336mzz(Z). The saturated vapor pressures of these working fluids are below or only slightly over 1.0 MPa at 100 ° C. The lower vapor pressures for HFO-1336mzz(E), HFO-1234ze(Z), HFC-245fa, HCFO-1224yd(Z), HFO-1233zd(E), and HFO-1336mzz(Z) would not demand a strong heat pipe envelope, thereby reducing the system manufacturing costs. More importantly, the vapor pressures of these working fluids all have very similar temperature dependence to that of HFC-245fa, which is the working fluids in the current generation heat pipes. The similar pressure-temperature profiles of these working fluids suggest that these working fluids can be "drop-in-replacement" for HFC-245fa in the current heat pipe systems with no or minimal modification.

The Merit Number

**[0029]** In addition to the above considerations, several properties inherent in the working fluids would impact their performance as heat pipe working fluids. For example, high liquid density and high latent heat reduce the fluid flow required (i.e., the amounts of working fluids required) to transport a given power. A low liquid viscosity reduces the liquid pressure drop for a given power.

Taking into accounts these properties of working fluids, a merit number (or figure of merit, M') may be used to assess the relative performance of a range of prospective working fluids. For a gravity type heat pipe (wickless heat pipe or thermosyphon), the merit number (M') is defined as follows:

$$M' = \left( \frac{L k_l^3 \rho_l^2}{\mu_l} \right)^{\frac{1}{4}}$$

wherein the dimension of the merit number $M'$ is $\frac{kg}{K^{3/4} S^{5/2}}$ , wherein L is the latent heat of vaporization with a dimension of (kJ/kg); $p_l$ is the density of the saturated liquid, with a dimension of kg/m³; $k_l$ is the liquid thermal conductivity; and $\mu_l$ is the hydrodynamic viscosity in dimension of Pa•s.

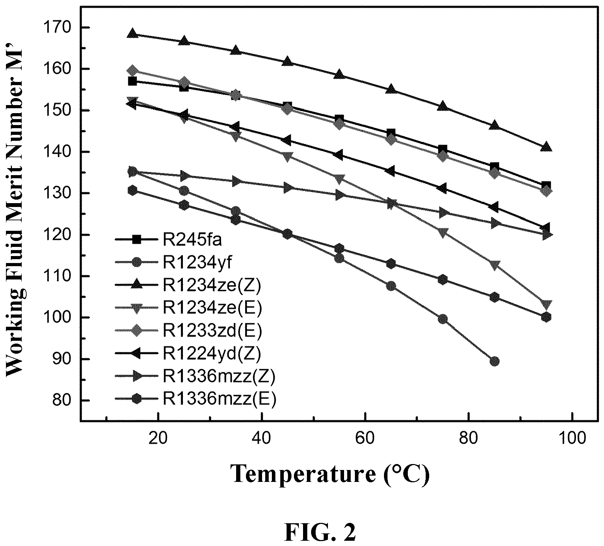

FIG. 2 shows the merit numbers (M') for several candidate working fluids within the temperature range of 15-95°C. Among these working fluids, HFO-1234ze(Z) has the highest merit numbers within this operating temperature range, even higher than those of HFC-245fa. Thus, HFO-1234ze(Z) not only is good for drop-in-replacement for HFC-245fa in current heat pipe system, but also will have high performance characteristics compared to HFC-245fa. Other working fluids having high merit numbers include HFO-1233ze€, HFO-1224yd(Z), HFO-1336mzz(Z) and HFO-1234ze(E). In contrast, the merit numbers of HFO-1234yf, which is the coolant of choice in modern automobiles, are significantly lower than others in this temperature range. Interestingly, the merit number of the trans isomer, HFO-1234ze(E), is significantly lower than those of its cis isomer, HFO-1234ze(Z), within this temperature range. Thus, HFO-1234ze(Z) would be a significantly better working fluid than HFO-1234ze(E) due to a larger merit number and lower saturation vapor pressures with a lower pressure-temperature dependency.

Latent Heat of Evaporation

Latent heat of evaporation relates to the amount of heat transfer in phase transition (e.g., from liquid phase to gas phase in the evaporation zone) per unit weight of a working fluid. As shown in the above merit number equation, the higher the latent heat of a working fluid is, the higher its merit number will be. Therefore, everything else being equal, working fluids with higher latent heats are preferred because they would require less amounts of the working fluids to transfer the same amounts of heat, as compare with a working fluid with a lower latent heat of evaporation.

The following Table 2 shows the latent heats of evaporation for various working fluids and mixtures.

Table 2

| Working Fluid | Latent Heat at 23°C (KJ/Kg) |
|---|---|
| HFC-245fa | 192.4 |
| HFO-1234ze (Z) | 207.4 |
| HFO-1336mzz (E) | 160.00 |
| HCFO-1233zd (E) | 192.2 |

(continued)

| Working Fluid | Latent Heat at 23°C (KJ/Kg) |
|---|---|
| HFO-1234yf | 147.0 |
| HFO-1234ze (E) | 168.4 |
| HCFO-1224yd | 164.9 |
| HFO-1336mzz (Z) | 169.4 |
| R1234ze (Z) /R1336mzz (E) =80/20 | 199.0 |
| R1234ze (Z) / R1336mzz (E) =20/80 | 169.6 |
| R1234ze (Z) /R1224yd=90/10 | 202.3 |
| R1234ze (Z) /R1224yd=10/90 | 168.1 |
| R1234ze (Z) /R1233zd (E) =90/10 | 204.9 |
| R1234ze (Z) /R1233zd (E) =10/90 | 192.7 |
| R1233zd (E) /R1224yd=90/10 | 188.9 |
| R1233zd (E) /R1224yd=10/90 | 167.0 |
| R1336mzz (E) /R1224yd=90/10 | 188.9 |
| R1336mzz (E) /R1224yd=10/90 | 165.3 |

As shown in Table 2, several working fluids (e.g., HFO-1234ze(Z) and mixtures thereof) have high latent heats of evaporation. With these working fluids, less amounts (mass) would be needed to achieve the same amount of heat transfer.

Testing the Performance of the Working Fluids

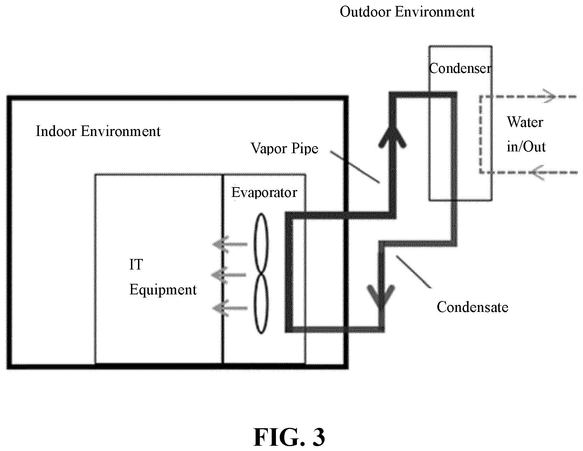

The cooling performance of working fluids of the invention are tested with a gravity type heat pipe setup. In this setup, two independent sets of gravity heat pipe systems (shown schematically in FIG. 3) are arranged closely together. One set of the gravity heat pipe systems uses HFC-245fa for comparison, and the other set of the gravity heat pipe systems uses a test working fluid of the invention (e.g., HFO-1234ze(Z), etc.). This side-by-side setup provides a better comparison between two working fluids. However, other setup (e.g., a single heat pipe system) may also be used for the tests. In addition, the performance of these working fluids may also be investigated with computer modeling/calculations.

Referring to FIG. 3, to run the test, the inner and outer back plates were opened at the same time for heat pipe circulation experiments. The experimental conditions were as follows: the indoor air intake dry bulb temperature was 35 °C, and the indoor air intake wet bulb temperature was 22 °C. The air circulation volumes are the same for the test working fluid (e.g., HFO-1234ze (Z)) and the comparison (e.g., HFC-245fa) system. The water temperatures for water circulating to the outside condensers are also the same for both systems (in: 15 °C and out: 20 °C).

The thermocycle performance parameters for the working fluids, as compared to that of HFC-245fa, are shown in Table 4. Under the same inlet and outlet water temperatures, the heat exchange capacities and coefficients of performance for several candidate working fluids are larger than those for HFC-245fa. The temperature of the inlet area of the cold passage can be maintained in compliance with the national standards, 18-27 °C.

Table 4. Gravity Heat Pipe Cycle Test Results

| Working Fluid | Temp. water inlet and outlet (°C) | Optimal amount (kg) | Air side heat Exchang e (KW) | Coefficient of Performanc e (COP, W/W) | Indoor Air outlet tempera ture (°C) | System Pressure (MPa) |
|---|---|---|---|---|---|---|
| HFC-245fa | | 1.05 | 5.98 | 56.42 | 23.50 | 0.143 |

(continued)

| Working Fluid | Temp. water inlet and outlet (°C) | Optimal amount (kg) | Air side heat Exchang e (KW) | Coefficient of Performanc e (COP, W/W) | Indoor Air outlet tempera ture (°C) | System Pressure (MPa) |
|---|---|---|---|---|---|---|
| HFO-1234ze(Z) | 15°C /20°C | 0.80 | 6.09 | 58.94 | 22.30 | 0.154 |
| HFO-1336mzz(E) | | 1.00 | 5.54 | 63.93 | 23.95 | 0.196 |
| HCFO-1233zd(E) | | 0.90 | 5.59 | 65.39 | 23.92 | 0.130 |
| HFO-1234yf | | 0.85 | 6.29 | 72.26 | 21.50 | 0.615 |
| HFO-1234ze(E) | | 0.88 | 5.36 | 77.70 | 24.35 | 0.455 |
| HCFO-1224yd(Z) | | 1.03 | 5.49 | 65.23 | 24.06 | 0.116 |
| HFO-1336mzz(Z) | | 1.05 | 5.29 | 59.63 | 24.43 | 0.065 |
| HFO-1234ze(Z)/ HFO-1336mzz(E) = 80/20 | | 1.0 | 6.43 | 61.41 | 22.08 | 0.162 |
| HFO-1234ze(Z)/ HFO-1336mzz(E) = 20/80 | | 0.95 | 5.31 | 62.35 | 24.26 | 0.177 |
| HFO-1234ze(Z)/ HCFO-1224yd = 90/10 | | 0.85 | 5.94 | 59.89 | 23.55 | 0.166 |
| HFO-1234ze(Z)/ HCFO-1224yd = 10/90 | | 1.03 | 5.55 | 64.29 | 23.95 | 0.146 |
| HFO-1234ze(Z)/ HCFO-1233zd(E) = 10/90 | | 0.97 | 5.68 | 62.15 | 23.85 | 0.132 |
| HFO-1234ze(Z)/ HCFO-1233zd(E) = 90/10 | | 0.94 | 5.99 | 60.12 | 23.50 | 0.165 |
| HCFO-1233zd(E)/ HCFO-1224yd = 10/90 | | 1.02 | 5.54 | 65.28 | 23.92 | 0.139 |
| HCFO-1233zd(E)/ HCFO-1224yd = 90/10 | | 0.98 | 5.55 | 65.35 | 23.90 | 0.125 |
| HFO-1336mzz(E)/ HCFO-1224yd =90/10 | | 1.00 | 5.52 | 64.12 | 23.98 | 0.173 |
| HFO-1336mzz(E)/ HCFO-1224yd = 10/90 | | 1.03 | 5.50 | 65.02 | 24.00 | 0.144 |

As shown in Table 4, working fluids of the invention in general have better performance parameters than those of the currently used working fluids, such as HFC-245fa. For example, these working fluids need less amounts to achieve the same heat transfer (i.e., lower optimal amount). The coefficients of performance of these working fluids are better than that of HFC-245fa, suggesting that all these fluids would have better performance than HFC-245fa. In addition, most of these working fluids have relative low system pressures, except for HFO-1234yf and HFO-1234ze(E), suggesting that these working fluids can be used to safely replace HFC-245fa without substantial modification to the heat pipes.

In addition, the optimal masses (amounts) needed are mostly lower than that for HFC-245fa, making these working fluids more economical to use than HFC-245fa.

These data together indicate that the HFOs and HCFOs of the invention are excellent working fluids for heat pipes, particularly, gravity type heat pipes. Examples of working fluids of the invention include HFO-1234ze(Z), HFO-1234ze(E), HFO-1234yf, HFO-1336mzz(Z), HFO-1336mzz(E), HFO-1224yd(Z), and HFO-1233zd(E), or a mixture thereof. Preferred working fluids of the invention include HFO-1234ze(Z), HFO-1233zd(E), HFO-1234yf, HFO-1336mzz(E), and HFO-1224yd(Z), or a mixture thereof.

A mixture of these working fluids may comprise two components with a ratio of 1:99, preferably 10:90, or 20:80, or 30:70, or 40:60, or 50:50, and any number therebetween. A preferred mixture comprises HFO-1234ze(Z), HFO-1233zd(E), or HFO-1336mzz(E) as one component. Non-limiting examples of a mixture of working fluids of the invention may include: HFO-1234ze(Z)/HFO-1336mzz(E) in a suitable ratio (e.g., 80/20); HFO-1234ze(Z)/HFO-1336mzz(E) in a suitable ratio (e.g., 20/80); HFO-1234ze(Z)/HCFO-1224yd in a suitable ratio (e.g., 90/10); HFO-1234ze(Z)/HCFO-1224yd in a suitable ratio (e.g., 10/90); HFO-1234ze(Z)/HCFO-1233zd(E) in a suitable ratio (e.g., 10/90); HFO-1234ze(Z)/HCFO-1233zd(E) in a suitable ratio (e.g., 90/10); HCFO-1233zd(E)/HCFO-1224yd in a suitable ratio (e.g., 10/90); HCFO-1233zd(E)/HCFO-1224yd in a suitable ratio (e.g., 90/10); HFO-1336mzz(E)/HCFO-1224yd in a suitable ratio (e.g., 90/10); and HFO-1336mzz(E)/HCFO-1224yd in a suitable ratio (e.g., 10/90).

That the HFOs of the invention have better performance coefficients than HFO-1234ze(E) and HFC-245fa is unexpected. HFC-245fa is considered a good alternative working fluid for a gravity type heat pipe. HFC-245fa lends itself to a number of heat transfer and working fluid applications based on its thermophysical properties. The thermophysical properties of HFC245fa make it suitable in various applications such as centrifugal chillers, Organic Rankine Cycle for energy recovery, sensible heat transfer in low-temperature refrigeration and passive cooling devices. (G.J. Zyhowski et al., "An Overview of the Properties and Application of HFC-245fa," International Refrigeration and Air Conditioning Conference, 2002).

In addition, the trans isomer, HFO-1234ze(E), was developed as a fourth-generation refrigerant to replace fluids such as HFC-134a. HFO-1234ze(E) has zero ozone-depletion potential (ODP=0), a very low global-warming potential (GWP < 1), even lower than $CO_2$. HFO-1234ze(E) has been adopted as working fluid in chillers, heat pumps, and supermarket refrigeration systems. (Wikipedia: https://en.wikipedia.org/wiki/1,3,3,3-Tetrafluoropropene). However, here we found that the cis isomer, HFO-1234ze(Z), would actually be between than the trans isomer, HFO-1234ze(E), for use in heat pipes (particularly, gravity type heat pipes) for cooling electronic equipment, internet data centers, etc. because the cis isomer, HFO-1234ze(Z), has a lower system pressure and would require less amount to transfer the same amount of heat. Embodiments of the invention have been illustrated with a limited number of examples. One skilled in the art would appreciate that these examples are for illustration only and are not meant to limit the scope of the invention and that other modifications and variations are possible without departing from the scope of the invention. Therefore, the scope of the invention should only be limited by the accompanying claims.

**Claims**

1.  A gravity heat pipe, comprising a working fluid selected from the group consisting of HFO-1234ze(Z), HFO-1234ze(E), HFO-1234yf, HFO-1336mzz(Z), HFO-1336mzz(E), HFO-1224yd(Z), HFO-1233zd(E), and a mixture thereof.

2.  The gravity heat pipe according to claim 1, wherein the working fluid is HFO-1234ze(Z), HFO-1234yf, HFO-1233zd(E), HFO-1336mzz(E), HFO-1224yd(Z), or a mixture thereof.

3.  The gravity heat pipe according to claim 1, wherein the working fluid is HFO-1234ze(Z).

4.  The gravity heat pipe according to claim 1, wherein the mixture comprises -1234ze(Z), HFO-1233zd(E), or HFO-1336mzz(E) as one component.

5.  The gravity heat pipe according to claim 1, wherein the mixture comprises HFO-1234ze(Z)/HFO-1336mzz(E); HFO-1234ze(Z)/HFO-1336mzz(E); HFO-1234ze(Z)/HCFO-1224yd; HFO-1234ze(Z)/HCFO-1224yd; HFO-1234ze(Z)/HCFO-1233zd(E); HFO-1234ze(Z)/HCFO-1233zd(E); HCFO-1233zd(E)/HCFO-1224yd; HCFO-1233zd(E)/HCFO-1224yd; HFO-1336mzz(E)/HCFO-1224yd; and HFO-1336mzz(E)/HCFO-1224yd.

6.  The gravity heat pipe according to claim 1, wherein the working fluid is used to directly replace a fluid of a gravity heat pipe originally designed to use HFC-245fa, HFC-134a or R410a.

7.  The gravity heat pipe according to claim 1, wherein said gravity heat pipe device is a flat-plate type gravity type heat pipe.

8.  The gravity heat pipe according to claim 1, wherein said gravity heat pipe is used for cooling of an electronic equipment, a computer, a communication base station, a server, or a data center.

9.  A method for cooling using the gravity heat pipe according to claim 1.

10. The method according to claim 9, wherein the working fluid is fluid selected from the group consisting of HFO-1234ze(Z), HFO-1234ze(E), HFO-1336mzz(Z), HFO-1336mzz(E), HFO-1224yd(Z), HFO-1233zd(E), and a mixture thereof.

11. The method according to claim 9, wherein the working fluid is fluid selected from the group consisting of HFO-1234ze(Z), HFO-1234yf, HFO-1233zd(E), HFO-1224yd(Z), or a mixture thereof.

12. The method according to claim 9, wherein the working fluid is HFO-1234ze(Z).

13. The method according to claim 9, wherein the gravity heat pipe is operated at a temperature from 0 °C to 100 °C.

FIG. 1

FIG. 2

FIG. 3

## INTERNATIONAL SEARCH REPORT

| International application No. |
|---|
| **PCT/CN2019/130393** |

| A. | CLASSIFICATION OF SUBJECT MATTER |
|---|---|

F01K 25/08(2006.01)i

According to International Patent Classification (IPC) or to both national classification and IPC

| B. | FIELDS SEARCHED |
|---|---|

Minimum documentation searched (classification system followed by classification symbols)

F01K25

Documentation searched other than minimum documentation to the extent that such documents are included in the fields searched

Electronic data base consulted during the international search (name of data base and, where practicable, search terms used)

CNABS, DWPI, SIPOABS, ISI Web of Knowledge: 氟, 氢氟, 介质, 氢氟烯烃, 热虹吸管, 热管, 四氟丙烯, 重力, 流体, 丙烯, 烯烃, HFO, tetrafluoropropene, heat, hydrofluoroolefin, heat transfer

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 104047649 A (HONEYWELL INTERNATIONAL INC.) 17 September 2014 (2014-09-17) <br> description, paragraphs 9-43 | 1-13 |
| X | CN 105452417 A (ASAHI GLASS CO., LTD.) 30 March 2016 (2016-03-30) <br> description, paragraphs 19-39 | 1-13 |
| X | CN 106029824 A (ASAHI GLASS CO., LTD.) 12 October 2016 (2016-10-12) <br> description, paragraphs 13-39 | 1-13 |
| X | CN 107532834 A (MITSUBISHI HEAVY IND LTD. et al.) 02 January 2018 (2018-01-02) <br> description, paragraphs 73-132 | 1-13 |
| X | CN 105542720 A (ASAHI GLASS CO., LTD.) 04 May 2016 (2016-05-04) <br> description, paragraphs 31-142 | 1-13 |
| X | EP 2880380 A1 (E I DU PONT DE NEMOURS AND COMPANY et al.) 10 June 2015 (2015-06-10) <br> description, pages 3-8 | 1-13 |
| X | CN 101553551 A (SOLVAY FLUOR GMBH ) 07 October 2009 (2009-10-07) <br> description, page 15, last paragraph to page 16, and paragraph 2 | 1-13 |

☑ Further documents are listed in the continuation of Box C.  ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 March 2020** | **31 March 2020** |

| Name and mailing address of the ISA/CN | Authorized officer |
|---|---|
| **China National Intellectual Property Administration (ISA/CN)** <br> **No. 6, Xitucheng Road, Jimenqiao Haidian District, Beijing 100088** <br> **China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2019/130393** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 102022937 A (BEIJING UNIVERSITY OF TECHNOLOGY) 20 April 2011 (2011-04-20) description, paragraphs 7-21, and figure 1 | 1-13 |

Form PCT/ISA/210 (second sheet) (January 2015)

**INTERNATIONAL SEARCH REPORT**
Information on patent family members

International application No.

**PCT/CN2019/130393**

| Patent document cited in search report | | | Publication date (day/month/year) | Patent family member(s) | | | Publication date (day/month/year) |
|---|---|---|---|---|---|---|---|
| CN | 104047649 | A | 17 September 2014 | JP | 2014211157 | A | 13 November 2014 |
| | | | | US | 2014260252 | A1 | 18 September 2014 |
| | | | | EP | 2778207 | A2 | 17 September 2014 |
| | | | | EP | 2778207 | A3 | 19 August 2015 |
| CN | 105452417 | A | 30 March 2016 | JP | WO2015005290 | A1 | 02 March 2017 |
| | | | | CN | 110373158 | A | 25 October 2019 |
| | | | | EP | 3020780 | A1 | 18 May 2016 |
| | | | | RU | 2664518 | C2 | 20 August 2018 |
| | | | | JP | 5850204 | B2 | 03 February 2016 |
| | | | | CN | 105452417 | B | 09 August 2019 |
| | | | | BR | 112015031288 | A2 | 25 July 2017 |
| | | | | EP | 3020780 | A4 | 01 March 2017 |
| | | | | JP | 2018138672 | A | 06 September 2018 |
| | | | | CN | 110373159 | A | 25 October 2019 |
| | | | | JP | 6330794 | B2 | 30 May 2018 |
| | | | | WO | 2015005290 | A1 | 15 January 2015 |
| | | | | US | 9828537 | B2 | 28 November 2017 |
| | | | | US | 2018057724 | A1 | 01 March 2018 |
| | | | | JP | 2019151850 | A | 12 September 2019 |
| | | | | DE | 112014003256 | T5 | 31 March 2016 |
| | | | | EP | 3020780 | B1 | 09 May 2018 |
| | | | | EP | 3470489 | A1 | 17 April 2019 |
| | | | | RU | 2016104613 | A | 17 August 2017 |
| | | | | JP | 6521139 | B2 | 29 May 2019 |
| | | | | US | 10472551 | B2 | 12 November 2019 |
| | | | | JP | 2016056374 | A | 21 April 2016 |
| | | | | US | 2016075927 | A1 | 17 March 2016 |
| | | | | RU | 2016104613 | A3 | 26 March 2018 |
| CN | 106029824 | A | 12 October 2016 | EP | 3109291 | A1 | 28 December 2016 |
| | | | | WO | 2015125534 | A1 | 27 August 2015 |
| | | | | JP | 6409595 | B2 | 24 October 2018 |
| | | | | EP | 3109291 | A4 | 25 October 2017 |
| | | | | JP | 6477679 | B2 | 06 March 2019 |
| | | | | JP | WO2015125534 | A1 | 30 March 2017 |
| | | | | US | 2016347981 | A1 | 01 December 2016 |
| | | | | JP | 2015172182 | A | 01 October 2015 |
| | | | | US | 10351746 | B2 | 16 July 2019 |
| CN | 107532834 | A | 02 January 2018 | EP | 3264012 | A4 | 30 May 2018 |
| | | | | JP | 2016194377 | A | 17 November 2016 |
| | | | | US | 2018066871 | A1 | 08 March 2018 |
| | | | | EP | 3264012 | A1 | 03 January 2018 |
| | | | | WO | 2016158822 | A1 | 06 October 2016 |
| | | | | US | 10443899 | B2 | 15 October 2019 |
| | | | | EP | 3264012 | B1 | 31 July 2019 |
| CN | 105542720 | A | 04 May 2016 | JP | 2018076526 | A | 17 May 2018 |
| | | | | JP | 6050459 | B2 | 21 December 2016 |
| | | | | EP | 2711406 | B1 | 19 July 2017 |
| | | | | JP | 2017071788 | A | 13 April 2017 |
| | | | | US | 2017101567 | A1 | 13 April 2017 |
| | | | | JP | WO2012157763 | A1 | 31 July 2014 |

Form PCT/ISA/210 (patent family annex) (January 2015)

**INTERNATIONAL SEARCH REPORT**
Information on patent family members

| International application No. |
| --- |
| **PCT/CN2019/130393** |

| Patent document cited in search report | | | Publication date (day/month/year) | Patent family member(s) | | | Publication date (day/month/year) |
| --- | --- | --- | --- | --- | --- | --- | --- |
| | | | | EP | 3239267 | A1 | 01 November 2017 |
| | | | | US | 9593274 | B2 | 14 March 2017 |
| | | | | JP | 6544422 | B2 | 17 July 2019 |
| | | | | US | 2017101568 | A1 | 13 April 2017 |
| | | | | EP | 3239268 | A1 | 01 November 2017 |
| | | | | JP | 2019178337 | A | 17 October 2019 |
| | | | | JP | 2016033219 | A | 10 March 2016 |
| | | | | EP | 2711406 | A1 | 26 March 2014 |
| | | | | JP | 6264432 | B2 | 24 January 2018 |
| | | | | JP | 5825345 | B2 | 02 December 2015 |
| | | | | US | 2014077122 | A1 | 20 March 2014 |
| | | | | WO | 2012157763 | A1 | 22 November 2012 |
| | | | | EP | 2711406 | A4 | 05 November 2014 |
| | | | | EP | 3239267 | B1 | 12 February 2020 |
| | | | | CN | 103534328 | B | 24 February 2016 |
| | | | | EP | 3239268 | B1 | 12 February 2020 |
| | | | | CN | 105542720 | B | 24 January 2020 |
| | | | | CN | 103534328 | A | 22 January 2014 |
| EP | 2880380 | A1 | 10 June 2015 | MX | 2015001477 | A | 08 May 2015 |
| | | | | BR | 112015002257 | A2 | 04 July 2017 |
| | | | | EP | 2880380 | B1 | 02 October 2019 |
| | | | | CA | 2880043 | A1 | 06 February 2014 |
| | | | | KR | 20150040880 | A | 15 April 2015 |
| | | | | JP | 2015529788 | A | 08 October 2015 |
| | | | | CN | 104508397 | A | 08 April 2015 |
| | | | | IN | 230DEN2015 | A | 12 June 2015 |
| | | | | CN | 104508397 | B | 19 October 2018 |
| | | | | WO | 2014022610 | A1 | 06 February 2014 |
| | | | | TW | 201413192 | A | 01 April 2014 |
| | | | | AU | 2013296453 | A2 | 29 January 2015 |
| | | | | JP | 2019152428 | A | 12 September 2019 |
| | | | | EP | 2880380 | A4 | 29 June 2016 |
| | | | | AU | 2013296453 | A1 | 29 January 2015 |
| | | | | SG | 11201500742W | A | 27 February 2015 |
| | | | | US | 2015191639 | A1 | 09 July 2015 |
| CN | 101553551 | A | 07 October 2009 | None | | | |
| CN | 102022937 | A | 20 April 2011 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G.J. ZYHOWSKI et al.** An Overview of the Properties and Application of HFC-245fa. *International Refrigeration and Air Conditioning Conference,* 2002